# EUROPÄISCHE PATENTSCHRIFT

(11) **EP 3 375 262 B1**
(45) Veröffentlichungstag und Bekanntmachung des Hinweises auf die Patenterteilung: **04.12.2019**
(21) Anmeldenummer: 16825321.9
(22) Anmeldetag: 10.11.2016
(51) Int. Cl.: H05K 1/02, B81B 7/00, G01P 1/00, H01L 23/498, H05K 1/14, H05K 1/18, H05K 3/20

(54) **LEITERBAHNENSTRUKTUR MIT EINEM SCHWINGUNGSGEDÄMPFT AUFGENOMMENEN BAUTEIL**
CONDUCTOR STRUCTURE HAVING A COMPONENT RECEIVED IN A VIBRATION-DAMPED MANNER
STRUCTURE DE PISTES CONDUCTRICES AVEC UN COMPOSANT LOGÉ AVEC AMORTISSEMENT DES VIBRATIONS

(30) Priorität: 12.11.2015 DE 102015014593; 12.11.2015 DE 202015007798 U
(43) Veröffentlichungstag der Anmeldung: 19.09.2018
(73) Patentinhaber: Possehl Electronics Deutschland GmbH, 75223 Niefern (DE)
(72) Erfinder: KURZEJA, Dietmar, 75223 Niefern (DE); MORGENTHALER, Frédéric, 75223 Niefern (DE)
(74) Vertreter: Leitner, Waldemar
(86) Internationale Anmeldenummer: PCT/EP2016/001870
(87) Internationale Veröffentlichungsnummer: WO 2017/080657

(56) Entgegenhaltungen:
- EP-A2- 2 789 578
- WO-A1-96/04772
- WO-A1-2008/142918
- WO-A1-2011/089066
- DE-A1-102012 201 486
- US-A1- 2008 260 181
- US-B1- 6 399 896

## Beschreibung

Die Erfindung betrifft eine Leiterbahnenstruktur mit einer Dämpfungseinrichtung für ein Bauteil, insbesondere ein elektronisches oder ein elektromechanisches Bauteil.

Leiterbahnenstrukturen mit einem elektronischen oder elektromechanischen Bauteil, insbesondere mit einem mikromechanischen Bauteil wie einer mikromechanischen Sensoreinrichtung, werden oft in Einbauumgebungen eingesetzt, in denen die Leiterplatte und/oder das von ihr aufgenommene Bauteil Erschütterungen ausgesetzt sind, welche zu Fehlfunktionen führen können. Als ein Beispiel hierfür ist z. B. einen Beschleunigungssenor zu nennen, der z. B. im automotiven Bereich in einer Vielzahl von Fahrzeugen eingesetzt ist. Es ist daher erforderlich, den auf der Leiterplatte aufgenommenen Sensor schwingungsgedämpft zu lagern, damit aus der Einbauumgebung resultierende Vibrationen und/oder Schwingungen nicht oder nur gedämpft auf den Sensor übertragen werden.

Aus der DE 10 2012 201 486 A1 ist eine Dämpfungsvorrichtung für eine mikromechanische Sensoreinrichtung bekannt, welche dazu dienen soll, störende Schwingungen von einem empfindlichen Sensorelement der Sensoreinrichtung fernzuhalten. Hierzu ist bei der aus den vorgenannten Druckschriften bekannten Dämpfungsvorrichtung vorgesehen, dass die Dämpfungseinrichtung eine Zwischenlageneinrichtung aus einem Leiterplattenmaterial aufweist, welche durch eine federnde Einrichtung in einen zentral angeordneten ersten Abschnitt und in einen, den ersten Abschnitt ringartigen umgebenen zweiten Abschnitt unterteilt ist. Auf diese Weise wird ein lateraler Abstand zwischen den beiden genannten Abschnitten ausgebildet. An der Unterseite des zweiten Abschnitts sind Kontaktierungselemente angeordnet, welche auch als Abstandselemente fungieren, die einen Abstand zwischen der die Dämpfungsvorrichtung tragenden Leiterplatte und der Zwischenlageneinrichtung der Dämpfungsvorrichtung bilden. Es wird also mittels der federnden Einrichtung ein schwingfähig gelagertes Gesamtsystem gebildet, welches schädliche Vibrations- und Schwingungseinflüsse auf die Sensoreinrichtung, welche auf dem ersten Abschnitt der Zwischenlageneinrichtung angeordnet ist, weitgehend dämpfen kann.

Gemäß einer weiteren Ausführungsform der aus der vorgenannten Druckschrift bekannten Dämpfungsvorrichtung sind im Bereich der federnden Einrichtung der ersten Zwischenlageneinrichtung Dämpfungsmaterialen vorgesehen. Es handelt sich bei diesen vorzugsweise um ein Elastomer, z. B. ein Silikonelastomer oder ein Silikongel, ein Gel mit Füllstoffen, z. B. sandartige Füllstoffe oder schaumstoffähnliche Materialen. Die Funktion dieses elastischen Dämpfungsmaterials besteht vor allem in einer Optimierung der Güte des Feder-Masse-Systems der Dämpfungsvorrichtung. Das Dämpfungsmaterial kann vor dem Kontaktieren und Löten in einem separaten Prozessschritt, z. B. durch Spritzen, Spritzgießen, Spritzpressen, Drucken oder Dispensen, aufgebracht werden, wodurch - nach den Angaben der vorgenannten Druckschrift - die Prozesskette und das Fertigungsverfahren der ersten Zwischenlageneinrichtung einer Dämpfungsvorrichtung vereinfacht wird.

Nachteilig an der bekannten Vorgehensweise ist, dass sie sehr kostenintensiv ist: der erste Abschnitt muß von den ihn renkartig umgebenden zweiten Abschnitt freigeschnitten werden, z. B. durch eine Lasertechnik, und zwischen dem ersten Abschnitt und dem zweiten Abschnitt der Zwischenlageneinrichtung muß dann die federnde Einrichtung angeordnet werden. Dies ist bekanntermaßen aufwendig. Um die Schwingungsdämpfung zu verbessern, ist - wie vorstehend beschrieben - bei der bekannten Dämpfungsvorrichtung vorgesehen, dass nach diesem Freistellen der beiden Bereiche und dem Verbinden derselben über die federnde Einrichtung noch Dämpfungsmaterialien wie Silikon oder dergleichen angespritzt werden müssen. Ein weiterer Nachteil der vorstehend beschriebenen Dämpfungsvorrichtung besteht darin, dass sie eine hohe Bauhöhe der sie einsetzenden Leiterbahnenstruktur bedingt.

Es ist Aufgabe der vorliegenden Erfindung, eine Leiterbahnenstruktur mit einer intrinsischen Dämpfungseinrichtung für ein Bauteil, insbesondere ein elektronisches oder elektromechanisches, insbesondere ein mikromechanisches Bauteil, derart weiterzuentwickeln, dass in einer einfachen Art und Weise eine Verringerung der auf das vorgenannte Bauteil einwirkenden Schwingungen und/oder Vibrationen erzielt wird.

Diese Aufgabe wird erfindungsgemäß durch eine Leiterbahnstruktur gemäß den Merkmalen der unabhängigen Ansprüche 1 bis 4 gelöst.

Durch die erfindungsgemäßen Maßnahmen wird in vorteilhafter Art und Weise eine Leiterbahnenstruktur mit einer intrinsischen Dämpfungsvorrichtung für ein elektronisches oder elektromechanisches Bauteil ausgebildet, welches sich durch eine einfache und somit kostengünstige Herstellbarkeit auszeichnet. In vorteilhafter Art und Weise ist es zur Ausbildung der intrinsischen Dämpfungsvorrichtung nun nicht mehr erforderlich, den das vorgenannte Bauteil tragenden Anschlussbereich der Leiterbahnenstruktur aus einem Grundkörper derselben freizuschneiden und dann diesen Anschlussbereich mit dem übrigen Bereich des Grundkörpers durch eine elastisch federnde Einrichtung, welche in ihrer Herstellung aufwendig und teuer ist, zu verbinden. Vielmehr sieht die erfindungsgemäße Leiterbahnenstruktur vor, dass die intrinsische Dämpfungsvorrichtung durch eine oder mehrere Schichten aus einem dämpfenden Material ausgebildet wird. Eine derartige Maßnahme besitzt nicht nur die vorgenannten Vorteile, sondern eine mit einer derart ausgebildeten intrinsischen Dämpfungsvorrichtung ausgestattete Leiterbahnenstruktur zeichnet sich durch eine geringe Bauhöhe aus.

Eine vorteilhafte Weiterbildung der Erfindung sieht vor, dass als dämpfendes Material ein dämpfender Klebstoff verwendet wird.

Eine weitere vorteilhafte Weiterbildung der Erfindung sieht vor, dass eine starre Klebstoffschicht vorgesehen ist. Eine derartige Maßnahme besitzt den Vorteil, dass hierdurch die Leiterbahnenstruktur in einfacher Art und Weise zu stabilisieren ist.

Weitere vorteilhafte Weiterbildungen der Erfindung sind Gegenstand der Unteransprüche.

Weitere Einzelheiten und Vorteile der Erfindung sind den Ausführungsbeispielen zu entnehmen, die im Folgenden anhand der Figuren beschrieben werden. Es zeigen:
- Figur 1: eine schematische Darstellung einer Leiterplatte mit einem von ihr getragenen Bauteil,
- Figur 2: ein erstes Ausführungsbeispiel einer Leiterbahnenstruktur,
- Figur 3: eine vergrößerte Darstellung eines Schnitts durch das erste Ausführungsbeispiel entlang der Linie A-A.
- Figur 4: ein illustratives Beispiel einer Leiterbahnenstruktur,
- Figur 5: eine vergrößerte Darstellung eines Schnitts durch das illustratives Beispiel entlang der Linie A-A.
- Figur 6: ein zweites Ausführungsbeispiel einer Leiterbahnenstruktur,
- Figur 7: eine vergrößerte Darstellung eines Schnitts durch das zweite Ausführungsbeispiel entlang der Linie A-A.
- Figur 8: ein drittes Ausführungsbeispiel einer Leiterbahnenstruktur,
- Figur 9: eine vergrößerte Darstellung eines Schnitts durch das drittes Ausführungsbeispiel entlang der Linie A-A.
- Figur 10: ein viertes Ausführungsbeispiel einer Leiterbahnenstruktur,
- Figur 11: eine vergrößerte Darstellung eines Schnitts durch das vierte Ausführungsbeispiel entlang der Linie A-A.

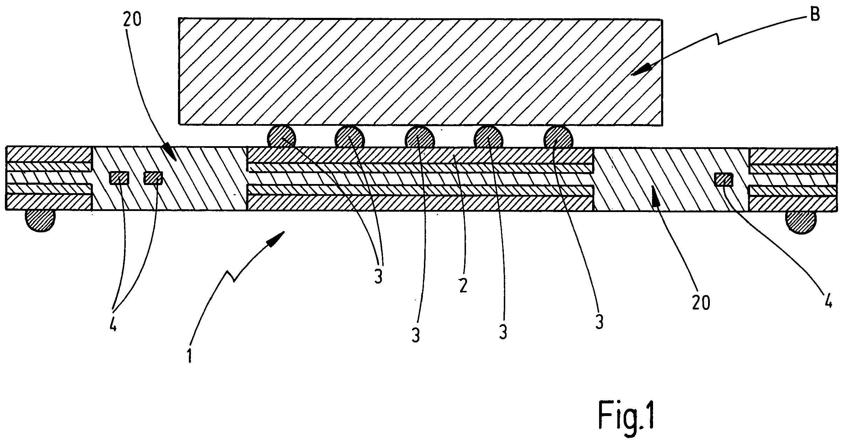

In Figur 1 ist eine schematische Ansicht einer Leiterbahnenstruktur 1 dargestellt, welche ein elektronisches und/oder elektromechanisches, insbesondere ein mikromechanisches Bauteil B trägt, wie z. B. einen Beschleunigungssensor oder dergleichen. Das Bauteil B ist auf einem Anschlussbereich 2 der Leiterbahnenstruktur 1 angeordnet, welcher hier als ein sogenannter Umverdrahtungsträger für das Bauteil B ausgebildet ist. Der Anschlussbereich 2 ist gegenüber dem ihn umgebenden Bereich der Leiterbahnenstruktur 1 schwingungsentkoppelt angeordnet, sodass eine intrinsische Dämpfung ausgebildet ist. Es soll hier angemerkt werden, dass hier sowie nachstehend unter dem Begriff "schwingungsentkoppelt" oder einem synonymen Ausdruck nicht nur eine vollständige Entkopplung, sondern auch eine teilweise Entkopplung von Schwingungen und/oder Vibrationen im Sinne einer Dämpfung verstanden werden soll.

Das Bauteil B ist durch Anschlusselemente 3 mit Leiterbahnen 4 der Leiterbahnenstruktur 1 elektrisch verbunden, wobei - wie die Figur 1 zeigt - durch diese Anschlusselemente 3 auch ein Abstand zwischen dem Bauteil B und der Oberfläche des Anschlussbereichs 2 der Leiterbahnenstruktur 1 ausgebildet ist.

Zwischen dem das Bauteil B tragenden Anschlussbereich 2 und der übrigen Leiterbahnenstruktur 1 ist eine Dämpfungseinrichtung 20 angeordnet. Exemplarische Ausführungsformen einer derartigen Dämpfungseinrichtung 20 sind in den nachfolgenden Ausführungsbeispielen beschrieben. In dem jeweils gezeigten Fall wird die Dämpfungseinrichtung 20 durch mindestens eine schwingungs- und/oder vibrationsdämpfende Materialschicht, insbesondere eine derartige Klebstoffschicht, ausgebildet.

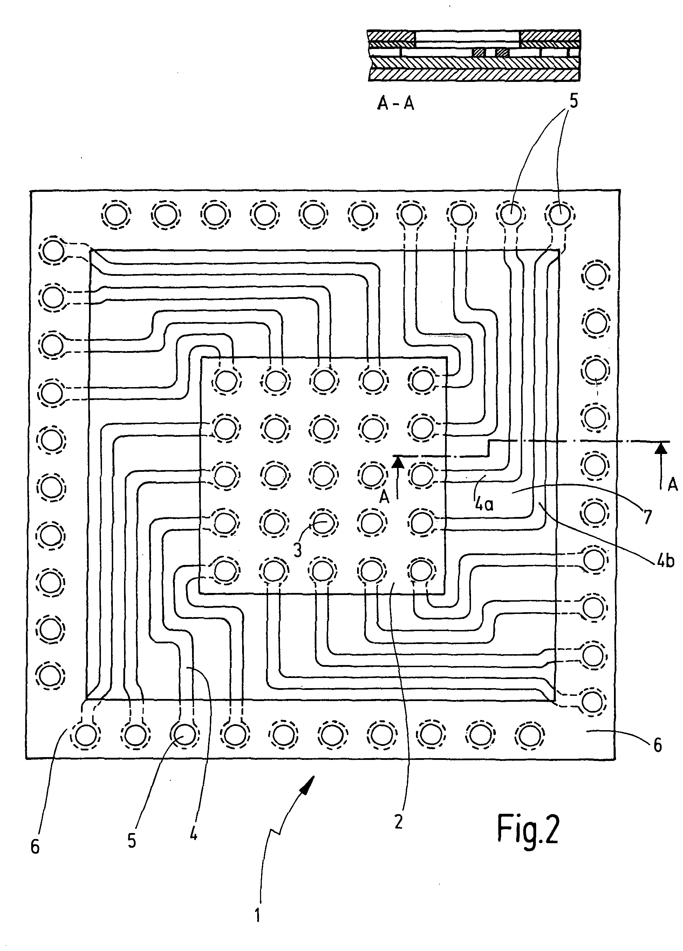

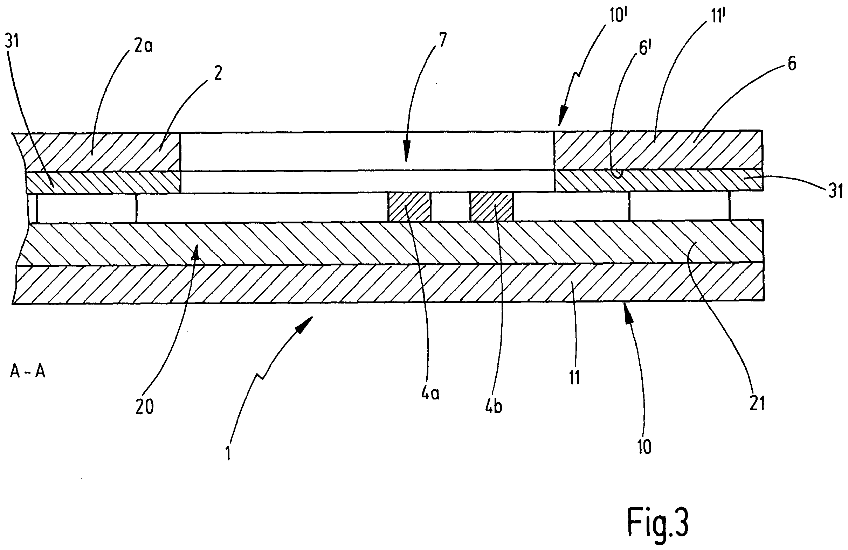

In den Figuren 2 und 3 ist ein erstes Ausführungsbeispiel einer Leiterbahnenstruktur 1 mit einer intrinsischen Dämpfungseinrichtung 20 gezeigt. Der einfacheren Darstellung halber wurde das in Figur 1 gezeigte Bauteil bei den vorgenannten Figuren sowie bei den weiteren, folgenden Figuren weggelassen. Die Figur 2 zeigt also eine Draufsicht auf die Leiterbahnenstruktur 1 und die Figur 3 eine vergrößerte Darstellung eines Schnitts entlang der Linie A-A der Figur 2. Der besseren Orientierung halber ist in Figur 2 der Schnitt der Figur 3 rechts oben maßstabsgetreu ebenfalls enthalten, sodass die räumliche Lagebeziehung zwischen den in Figur 3 ersichtlichen Strukturen und denjenigen der Figur 2 erkennbar ist.

Man erkennt in den Figuren 2 und 3 den - das in diesen Figuren nicht gezeigte Bauteil B tragenden - Anschlussbereich 2 der Leiterbahnenstruktur 1, welcher die bereits vorstehend genannten Anschlusselemente 3 für das Bauteil B aufweist. Diese sind über Leiterbahnen 4 mit Kontaktierungselementen 5 der Leiterbahnenstruktur 1 verbunden, welche in deren Randbereich 6 angeordnet sind. Ein derartiger Aufbau einer Leiterbahnenstruktur 1 ist bekannt und muss daher nicht mehr weiter beschrieben werden.

Der genauere Aufbau der Leiterbahnenstruktur 1 ist am besten aus der Figur 3 ersichtlich, welche - wie vorstehend aufgeführt - eine Schnittansicht entlang der Linie A-A der Figur 2 darstellt. Man erkennt hier insbesondere die Leiterbahnen 4a und 4b der Figur 2 sowie den Randbereich 6 der Leiterbahnenstruktur 1 und den Anschlussbereich 2 für das Bauteil B.

Die Leiterbahnenstruktur 1 weist einen unteren Grundkörper 10 aus einem geeigneten Trägermaterial 11, insbesondere aus einem Laminat, auf. Darüber ist eine Schicht 21 aus einem dämpfenden Material, insbesondere aus einem dämpfenden Klebstoff angeordnet, die als intrinsische Dämpfungseinrichtung 20 der Leiterbahnenstruktur 1 fungiert.

Auf der Schicht 21 sind die Leiterbahnen 4, also auch die Leiterbahnen 4a und 4b, gelagert. Über der die Leiterbahnen 4, 4a, 4b aufnehmenden Ebene der Leiterbahnenstruktur 1 ist ein oberer Grundkörper 10' angeordnet, der aus einem Trägermaterial 11', insbesondere einem Laminat, ausgebildet ist und an seiner Unterseite eine Schicht aus starrem Klebstoff 31 trägt. Von diesem oberen Grundkörper 10' ist in Figur 3 - entsprechend dem Schnitt entlang der Linie A-A der Figur 3 - der Randbereich 6 sowie ein Teil des Anschlussbereichs 2 gezeigt. Auch hier ist wiederum der obere Grundkörper 10' durch ein Trägermaterial 11', insbesondere ein Laminat ausgebildet. Unter diesem ist eine Schicht 31 aus einem starren Klebstoff angeordnet.

Die starre Klebstoffschicht 31 dient dazu, die Leiterbahnenstruktur 1 zu stabilisieren und eine hinreichende Verbindung zwischen entsprechenden Bereichen des Trägermaterials 11' des Grundkörpers 10' und der Schicht 21 aus dem dämpfenden Klebstoff auszubilden. Dem Fachmann ist ersichtlich, dass diese Schicht 31 aus starren Klebstoff entfallen kann, wenn die adhäsiven Eigenschaften des die Schicht 21 ausbildenden, dämpfenden Klebstoffs eine Verbindung zwischen den Leiterplattenbereichen 2a, 6 und diesem Klebstoff erlauben.

Wie ebenfalls aus der Figur 3 am besten ersichtlich ist, ist zwischen dem Randbereich 6 und dem Anschlussbereich 2 ein Freiraum 7 vorgesehen, sodass keine mechanische Verbindung zwischen diesem Randbereich 6 und dem derart freigestellten Anschlussbereich 2 besteht. Der Anschlussbereich 2 ist somit schwing- und/oder vibrationsfähig auf der dämpfenden Schicht 21 gelagert. Dies hat zur Folge, dass auf die Leiterbahnenstruktur 1 auftreffende Schwingungen und/oder Vibrationen nicht oder nur gedämpft auf den Anschlussbereich 2 übertragen werden.

Zur Herstellung der in den Figuren 2 und 3 gezeigten Leiterbahnenstruktur 1 wird zuerst auf dem Trägermaterial 11 die dämpfende Schicht 21 der intrinsischen Dämpfungsvorrichtung 20 aufgetragen. Dann wird ein die Leiterbahnen 4, 4a, 4b enthaltender Leiterbahnen-Rahmen auf diese Schicht 21 aufgebracht. Danach wird das den Randbereich 6 sowie den Anschlussbereich 2 ausbildende Trägermaterial, erforderlichenfalls mit der an seiner Unterseite angeordneten Schicht 31 aus einem starren Klebstoff, aufgebracht. Es ist aber auch möglich, dass zuerst auf die durch das Trägermaterial 11, die Schicht 21 und die Leiterbahnen 4, 4a, 4b ausgebildeten Teil-Struktur der Leiterbahnenstruktur 1 die Schicht 31 aus einem starren Klebstoff aufgebracht und auf diese Schicht 31 dann das Trägermaterial des Randbereichs 6 sowie derjenige des Anschlussbereichs 2 aufgebracht wird. Selbstverständlich ist es auch möglich, die vorstehend beschriebene Herstellung der Leiterbahnenstruktur 1 "umzukehren", d. h., in der Darstellung der Figuren 2 und 3, von oben beginnend, zuerst den Randbereich 6 sowie den Anschlussbereich 2 auszubilden und darauf die weiteren strukturellen Komponenten der Leiterbahnenstruktur 1 wie vorstehend beschrieben aber "in der umgekehrten Reihenfolge" aufzubringen.

Die beschriebene Ausbildung der Leiterbahnenstruktur 1 zeichnet sich dadurch aus, dass es nicht mehr erforderlich ist, einzelne Bereiche eines Trägerkörpers freizuschneiden und zwischen ihnen eine als Dämpfungsvorrichtung fungierende federnde Einrichtung vorzusehen, wie dies bei dem bekannten Aufbau der Fall ist. Die beschriebene Leiterbahnenstruktur 1 zeichnet sich somit durch ihre einfache und damit kostengünstige Herstellbarkeit und eine geringe Aufbauhöhe aus.

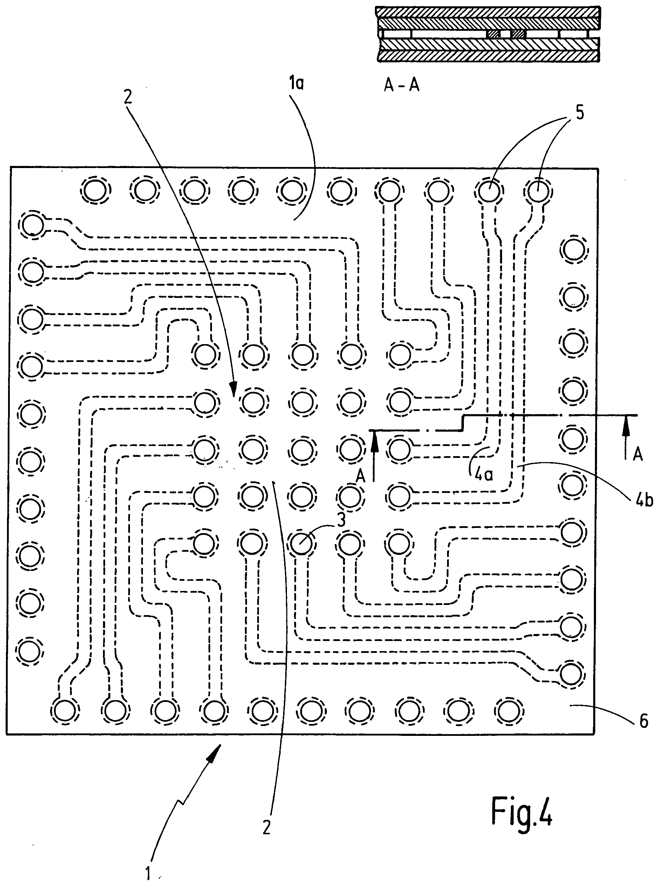

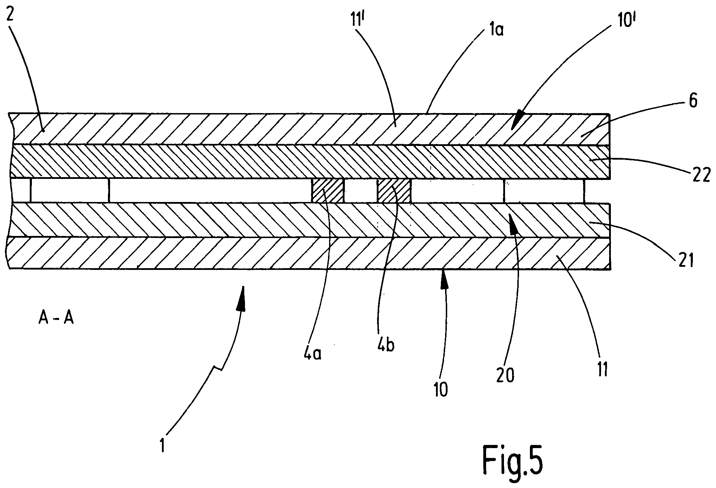

Die Figuren 4 und 5 zeigen ein nicht beanspruchtes, illustratives Beispiel einer Leiterbahnenstruktur 1, wobei einander entsprechende Bauteile mit den gleichen Bezugszeichen versehen und nicht mehr näher beschrieben werden. Der schichtweise Aufbau der Leiterbahnenstruktur 1 der Figur 4 ist wiederum aus dem Schnitt der Figur 5 ersichtlich. Der wesentliche Unterschied zwischen dem ersten und zweiten Ausführungsbeispiel besteht nun darin, dass - wie auch aus der Draufsicht der Figur 4 ersichtlich ist - die Leiterbahnenstruktur 1 des zweiten Ausführungsbeispiels eine geschlossene Oberfläche 1a besitzt. Dies ist auch daraus ersichtlich, dass in der Figur 4 - im Gegensatz zur Figur 2 - die Leiterbahnen 4, 4a, 4b - da nicht sichtbar - strichliert dargestellt sind. Aus Figur 5 erkennt man wieder, dass die Leiterbahnenstruktur 1 einen unteren Grundkörper 10 aus einem entsprechenden Trägermaterial 11, insbesondere einem Laminat, aufweist, über den die als intrinsische Dämpfungseinrichtung 20 fungierende Schicht 21 aus einem dämpfenden Material, insbesondere aus einem Klebstoff, angeordnet ist. Diese trägt die Leiterbahnen 4, 4a, 4b. Über den Leiterbahnen 4, 4a, 4b ist eine weitere Schicht 22 aus einem dämpfenden Klebstoff vorgesehen, sodass die Dämpfungseinrichtung 20 in dem hier beschriebenen Fall die Schichten 21 und 22, die jeweils aus einem dämpfenden Material, insbesondere aus einem Klebstoff, ausgebildet sind, enthält. Die Leiterbahnen 4, 4a, 4b sind somit zwischen diesen beiden Schichten 21 und 22 eingebettet. Über der Schicht 22 ist wiederum ein dem unteren Grundkörper 10 entsprechender oberer Grundkörper 10' aus einem entsprechenden Trägermaterial 11', insbesondere einem Laminat, angeordnet.

Die Herstellung der Leiterbahnenstruktur 1 erfolgt wiederum entsprechend dem ersten Ausführungsbeispiel, so dass diese nicht mehr im Detail beschrieben werden muss: auf das Trägermaterial 11 des unteren Grundkörpers 10 wird die Schicht 21 aus dem dämpfenden Klebstoff aufgebracht. Darauf werden die Leiterbahnen 4, 4a, 4b angeordnet. Dann wird die Schicht 22 aus einem dämpfenden Material aufgebracht und anschließend das Trägermaterial 11' des oberen Grundkörpers 10'. Selbstverständlich kann bei diesem illustrativen Beispiel vorgesehen sein, dass - in den Figuren nicht gezeigt - den Schichten 31 des ersten Ausführungsbeispiels entsprechende Schichten zwischen dem Trägermaterial 11 und der Schicht 21 und/oder zwischen der Schicht 22 und dem Trägermaterial 11' des oberen Grundkörpers 10' vorgesehen sind.

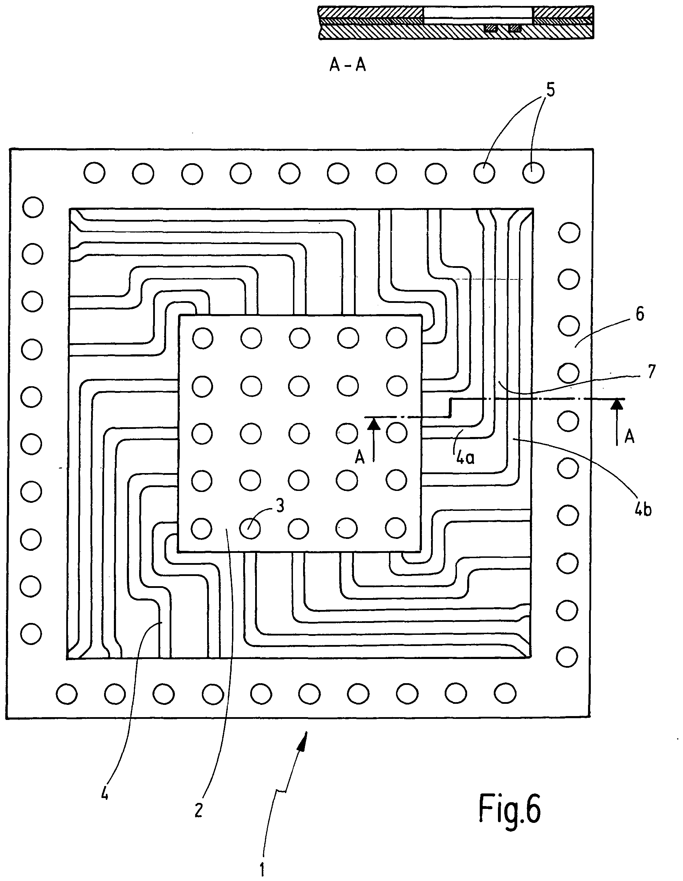

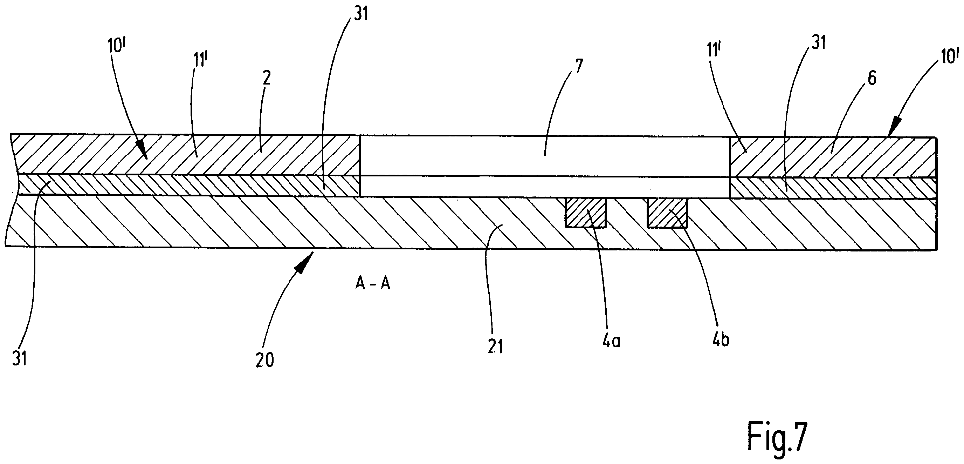

Die Figuren 6 und 7 zeigen nun ein zweites Ausführungsbeispiel einer Leiterbahnenstruktur 1, wobei einander entsprechende Bauteile wiederum mit den gleichen Bezugszeichen versehen und nicht mehr näher beschrieben werden. Das dritte Ausführungsbeispiel entspricht seinem Grundaufbau nach dem ersten Ausführungsbeispiel. Man erkennt aus der Draufsicht der Figur 6, dass die Leiterbahnen 4, 4a, 4b freiliegend angeordnet sind.

Der Grundkörper 10' des zweiten Ausführungsbeispiels entspricht seinem Aufbau nach dem Grundkörper 10' des ersten Ausführungsbeispiels, so dass unter der die Deckschicht der Leiterbahnenstruktur 1 ausbildenden oberen Schicht aus einem geeigneten Trägermaterial 11' die Schicht 31 aus einem starren Klebstoff angeordnet ist. Unter dieser Schicht 31 sind die Leiterbahnen 4, 4a, 4b angeordnet, sie "hängen" also unter der Schicht 31. Auf die Schicht 31 des Grundkörpers 10' wird dann die Schicht 21 aus dem dämpfenden Material aufgetragen, welche die intrinsische Dämpfungsvorrichtung 20 ausbildet. Diese Maßnahmen erlauben es, die Schicht 21, welche hier die intrinsische Dämpfungseinrichtung 20 ausbildet, großflächig, z. B. durch einen Dispens-Vorgang, auf den Grundkörper 10 der Leiterbahnenstruktur 1 aufzubringen. Dies vereinfacht die Herstellung einer derartigen Leiterbahnenstruktur 1 mit intrinsischer Dämpfungsvorrichtung 20.

Im zweiten Ausführungsbeispiel der Figuren 6 und 7 ist nun wiederum vorgesehen, dass zwischen der Schicht 21 und dem Trägermaterial 11' des Grundkörpers 10' eine Schicht 31 aus einem starren Klebstoff vorgesehen ist. Auch hier gilt wieder, dass diese der Versteifung der Leiterbahnenstruktur 1 dienende Schicht 31 entfallen kann, wenn zur Ausbildung der Schicht 21 ein dämpfender Klebstoff verwendet wird, der hinreichend große Adhäsionseigenschaften aufweist, um damit eine zuverlässige Verbindung mit dem Material des Grundkörpers 10 einzugehen.

Die Herstellung der Leiterbahnenstruktur 1 erfolgt hierbei derart, dass zuerst der obere Grundkörper 10' mit dem Trägermaterial 11' und der Schicht aus starrem Klebstoff 31 ausgebildet wird, und dann auf dieser Schicht 31 aus starrem Klebstoff die Leiterbahnen 4, 4a, 4b angeordnet werden. Dann wird großflächig die Schicht 21 aus dämpfenden Material, insbesondere aus einem dämpfenden Klebstoff, aufgebracht.

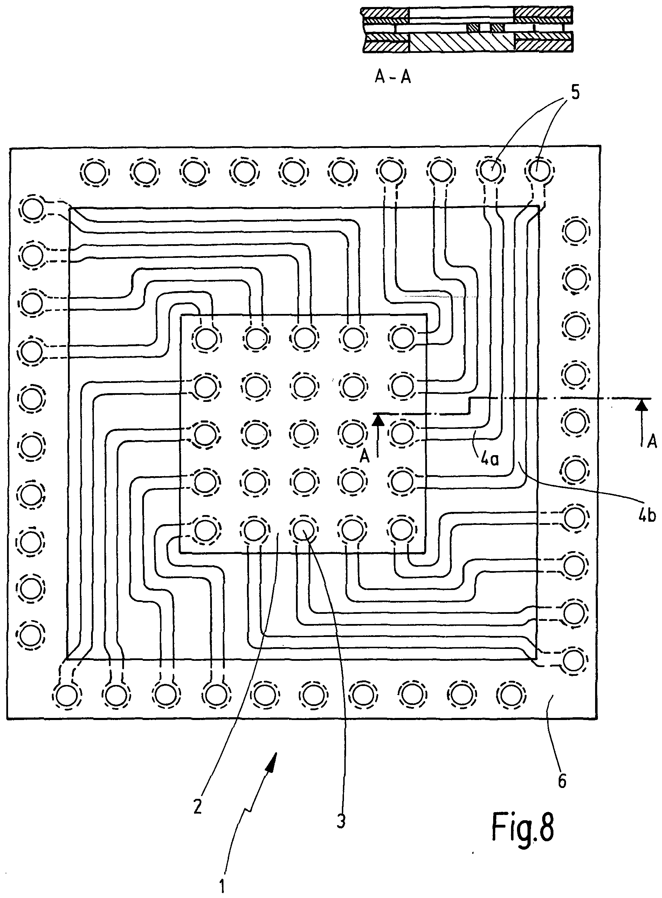

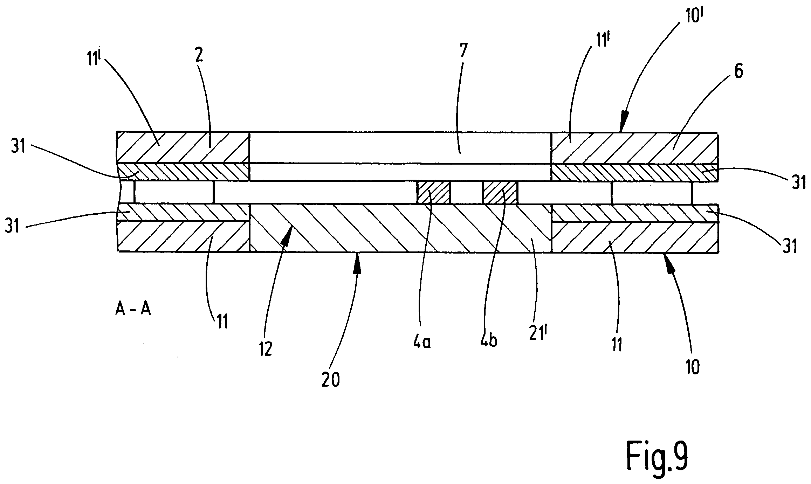

In den Figuren 8 und 9 ist in ein drittes Ausführungsbeispiel einer Leiterbahnenstruktur 1 dargestellt, wobei auch hier wiederum einander entsprechende Bauteile mit den gleichen Bezugszeichen versehen und nicht mehr weiter beschrieben werden. Das dritte Ausführungsbeispiel entspricht dem zweiten Ausführungsbeispiel, mit der Maßgabe, dass die Schicht 21 aus dämpfendem Material, insbesondere aus Klebstoff, nicht - wie im zweiten Ausführungsbeispiel - großflächig aufgetragen wurde, sondern die Ausgestaltung von lokalen Polstern ("pads") 21' aus einem dämpfenden Material, insbesondere aus Klebstoff, besitzt.

Hierzu ist vorgesehen, dass das Trägermaterial 11 des unteren Grundkörpers 10 der Leiterbahnenstruktur 1 mindestens eine Ausnehmung 12 aufweist, in welche dann die vorgenannten lokalen Polster 21' eingebracht werden. Dies kann wiederum durch Einsetzen von bereits vorgefertigten lokalen Polstern oder durch ein lokales Auftragen der Schicht 21 aus dem dämpfenden Material bewerkstelligt werden.

Alternativ ist es möglich, dass anstelle des unteren Grundkörpers 10 der obere Grundkörper 10' mindestens eine derartige Ausnehmung 12 aufweist, in welche dann der oder die vorgenannten lokalen Polster 21' eingebracht werden. Der untere Grundkörper 10 kann dann gegebenenfalls entfallen. Natürlich ist auch eine Kombination dieser Maßnahmen möglich, dass also sowohl der Grundkörper 10 als auch der Grundkörper 10' mindestens eine entsprechende Ausnehmung 12 besitzen.

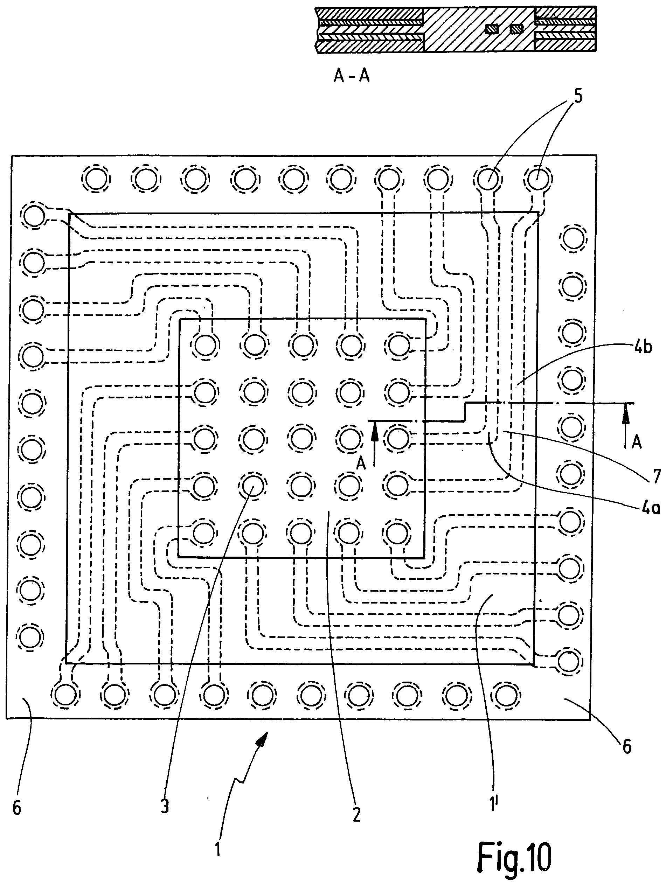

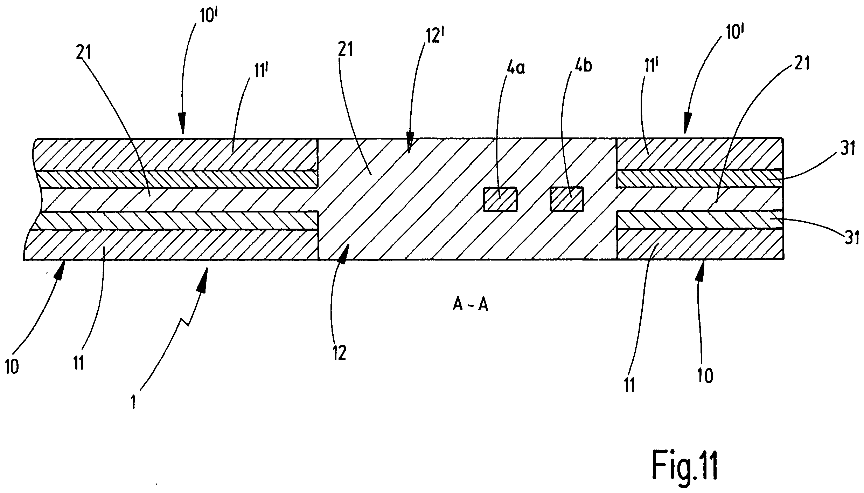

In den Figuren 10 und 11 ist ein viertes Ausführungsbeispiel der Leiterbahnenstruktur 1 dargestellt, wobei auch hier die entsprechenden Bauteile mit den gleichen Bezugszeichen versehen und nicht mehr weiter beschrieben werden. Der Aufbau des viertes Ausführungsbeispiels entspricht dem Grunde nach demjenigen des dritten Ausführungsbeispiels, die Leiterbahnenstruktur 1 weist also eine geschlossene Oberfläche 1' auf, wie sich aus der strichlierten Darstellung der Leiterbahnen 4, 4a, 4b ergibt. Der untere Grundkörper 10 und der obere Grundkörper 10' weisen jeweils eine Ausnehmung 12 bzw. 12' auf, welche - wie am besten aus Figur 11 ersichtlich - durch eine Schicht aus dämpfendem Material 21, insbesondere aus einem dämpfenden Klebstoff, gefüllt wird. Der wesentliche Unterschied zwischen dem vierten und dem vierten Ausführungsbeispiel ist also, dass bei letztgenanntem anstelle lokal aufgebrachter, dämpfenden Polster 21' ein dämpfendes Material, insbesondere ein dämpfender Klebstoff, eingespritzt, bedruckt und dispensert wird.

Die Leiterbahnenstruktur 1 des vierten Ausführungsbeispiels wird mittels einer Standard-Laminiertechnik hergestellt. Die Leiterbahnen 4, 4a, 4b und Trägerfolien mit Klebschichten werden in ein entsprechendes Spritzgießwerkzeug gelegt. Im geschlossenen Spritzgießwerkzeug wird die formgebende Kavität im Bereich der freigestellten Leiterbahnen im Freiraum 7 mit dämpfenden Material gefüllt, welches die Schicht 21 ausbildet. Die Laminierung der Trägerschichten auf die Leiterbahnen 4, 4a, 4b kann dabei wahlweise als dem vorgenannten Spritzgießprozeß vorgeschalteten Prozeß als auch während des Spritzgießvorgangs im Spritzgießwerkzeug erfolgen.

Zusammenfassend ist festzuhalten, dass durch die beschriebenen Maßnahmen eine Leiterbahnenstruktur 1 mit einer intrinsischen Dämpfungsvorrichtung 20 ausgebildet wird, welche sich durch ihre einfache und somit kostengünstige Herstellbarkeit auszeichnet. Es ist zur Ausbildung der intrinsischen Dämpfungsvorrichtung 20 nun nicht mehr erforderlich, zur Ausbildung des Schwingungs- und/oder vibrationsgedämpften Anschlussbereichs 2 aus dem unteren Grundkörper 10 und/oder dem oberen Grundkörper 10' entsprechende Abschnitte freizuschneiden, die dann durch eine elastisch federnde Einrichtung verbunden werden. Vielmehr ist vorgesehen, dass die intrinsische Dämpfungsvorrichtung 20 durch eine oder mehrere Schichten 21, 22 aus einem dämpfenden Material, insbesondere einem dämpfenden Klebstoff, ausgebildet werden. Eine derartige Maßnahme besitzt den weiteren Vorteil, dass sich die mit der beschriebenen Dämpfungsvorrichtung 20 ausgestattete Leiterbahnenstruktur 1 durch eine geringe Bauhöhe auszeichnet.

## Patentansprüche

1. Leiterbahnenstruktur mit einer Dämpfungseinrichtung für ein Bauteil, insbesondere für ein elektronisches oder elektromechanisches, insbesondere ein mikroelektronisches Bauteil, die einen ersten Grundkörper (10') aus einem Trägermaterial (11') mit einem Anschlussbereich (2) zur Aufnahme des schwingungs- und/oder vibrationsgedämpften Bauteils (B) aufweist, wobei der Anschlussbereich (2) von dem ihm umgebenden Bereich des ersten Grundkörpers (10') durch einen Freiraum (7) getrennt, schwingungs- und/oder vibrationsentkoppelt angeordnet ist und mit einer intrinsischen Dämpfungsvorrichtung (20) der Leiterbahnenstruktur (1) zusammenwirkt, wobei die Leiterbahnenstruktur (1) einen beabstandet unter dem ersten Grundkörper (10') angeordneten zweiten Grundkörper (10) aufweist, wobei über dem zweiten Grundkörper (10) der Leiterbahnenstruktur (1) mindestens eine Schicht (21) aus einem dämpfenden Material, insbesondere aus einem dämpfenden Klebstoff, angeordnet ist, so dass die durch die vorgenannte mindestens eine Schicht (21) ausgebildete intrinsische Dämpfungsvorrichtung (20) zwischen dem Anschlussbereich (2) des ersten Grundkörpers (10'), dem Freiraum (7), dem den Anschlussbereich (2) umgebenden Bereich (6) des ersten Grundkörpers (10') und dem unter dem Anschlussbereich (2) liegenden Bereich des zweiten Grundkörpers (10) angeordnet ist.

2. Leiterbahnenstruktur mit einer Dämpfungseinrichtung für ein Bauteil, insbesondere für ein elektronisches oder elektromechanisches, insbesondere ein mikroelektronisches Bauteil, die einen ersten Grundkörper (10') aus einem Trägermaterial (11') mit einem Anschlussbereich (2) zur Aufnahme des schwingungs- und/oder vibrationsgedämpften Bauteils (B) aufweist, wobei der Anschlussbereich (2) von dem ihm umgebenden Bereich des ersten Grundkörpers (10') durch einen Freiraum (7) getrennt, schwingungs- und/oder vibrationsentkoppelt angeordnet ist und mit einer intrinsischen Dämpfungsvorrichtung (20) der Leiterbahnenstruktur (1) zusammenwirkt, wobei unter dem ersten Grundkörper (10') mindestens eine Schicht (21) aus einem dämpfenden Material, insbesondere aus einem dämpfenden Klebstoff, angeordnet ist, wobei die unter dem ersten Grundkörper (10') angeordnete mindestens eine Schicht (21) großflächig auf diesem aufgetragen ist, so dass die durch die vorgenannte mindestens eine Schicht (21) ausgebildete intrinsische Dämpfungsvorrichtung (20) unter dem Anschlussbereich (2) des ersten Grundkörpers (10') und dem diesen Anschlussbereich (2) umgebenden Bereich des ersten Grundkörpers (10') und unter dem Freiraum (7) angeordnet ist.

3. Leiterbahnenstruktur mit einer Dämpfungseinrichtung für ein Bauteil, insbesondere für ein elektronisches oder elektromechanisches, insbesondere ein mikroelektronisches Bauteil, die einen ersten Grundkörper (10') aus einem Trägermaterial mit einem Anschlussbereich (2) zur Aufnahme eines schwingungs- und/oder vibrationsgedämpften Bauteils (B) aufweist, wobei der Anschlussbereich (2) von dem ihm umgebenden Bereich des ersten Grundkörpers (10') durch einen Freiraum (7) getrennt, schwingungs- und/oder vibrationsentkoppelt angeordnet ist und mit einer intrinsischen Dämpfungsvorrichtung (20) der Leiterbahnenstruktur (1) zusammenwirkt, wobei die Leiterbahnenstruktur (1) einen beabstandet unter dem ersten Grundkörper (10') angeordneten zweiten Grundkörper (10) aufweist, und wobei mindestens ein Grundkörper (10; 10') der Leiterbahnenstruktur (1) mindestens eine Ausnehmung (12) besitzt, in der ein Polster (21') aus dämpfendem Material eingesetzt ist.

4. Leiterbahnenstruktur mit einer Dämpfungseinrichtung für ein Bauteil, insbesondere für ein elektronisches oder elektromechanisches, insbesondere ein mikroelektronisches Bauteil, die einen ersten Grundkörper (10') aus einem Trägermaterial mit einem Anschlussbereich (2) zur Aufnahme eines schwingungs- und/oder vibrationsgedämpften Bauteils (B) aufweist, wobei der Anschlussbereich (2) von dem ihm umgebenden Bereich des ersten Grundkörpers (10') durch eine Ausnehmung (12') getrennt, schwingungs- und/oder vibrationsentkoppelt angeordnet ist und mit einer intrinsischen Dämpfungsvorrichtung (20) der Leiterbahnenstruktur (1) zusammenwirkt, wobei die Leiterbahnenstruktur (1) einen beabstandet unter dem ersten Grundkörper (10') angeordneten zweiten Grundkörper (10) aufweist, und wobei der zweite Grundkörper (10) der Leiterbahnenstruktur (1) mindestens eine weitere Ausnehmung (12) besitzt, wobei zur Ausbildung einer intrinsischen Dämpfungsvorrichtung (20) in die Ausnehmungen (12, 12') sowie zwischen dem ersten Grundkörper (10') und dem zweiten Grundkörper (10) eine Schicht (21) aus einem dämpfenden Material, insbesondere einem dämpfenden Klebstoff, eingebracht ist.

5. Leiterbahnenstruktur nach einem der vorangehenden Ansprüche, **dadurch gekennzeichnet, dass** unter dem oberen Grundkörper (10') mindestens eine weitere Schicht (22) der intrinsischen Dämpfungsvorrichtung (20) angeordnet ist, die aus einem dämpfenden Material, insbesondere einem dämpfenden Klebstoff ausgebildet ist.

6. Leiterbahnenstruktur nach Anspruch 1, **dadurch gekennzeichnet, dass** die mindestens eine Schicht (21; 22) aus dämpfendem Material zur Ausbildung der intrinsischen Dämpfungsvorrichtung (20) auf einer Oberseite des zweiten Grundkörpers (10) und/oder einer Unterseite des ersten Grundkörpers (10; 10') aufgetragen ist.

7. Leiterbahnenstruktur nach einem der vorangehenden Ansprüche, **dadurch gekennzeichnet, dass** Leiterbahnen (4; 4a, 4b) auf oder in der dämpfenden Schicht (21; 22) der intrinsischen Dämpfungsvorrichtung (20) angeordnet sind.

8. Leiterbahnenstruktur nach Anspruch 3 **dadurch gekennzeichnet, dass** der untere Grundkörper (10) und der obere Grundkörper (10') der Leiterbahnenstruktur (1) jeweils mindestens eine Ausnehmung (12; 12') besitzen, in der jeweils ein Polster (21') aus dämpfenden Material eingesetzt ist.

9. Leiterbahnenstruktur nach einem der vorangehenden Ansprüche, **dadurch gekennzeichnet, dass** an mindestens einem Grundkörper (10; 10') mindestens eine Schicht (31) aus einem starren Klebstoff angeordnet ist.

10. Leiterbahnenstruktur nach einem der vorangehenden Ansprüche, **dadurch gekennzeichnet, dass** die Leiterbahnenstruktur (1) durch eine Laminiertechnik hergestellt ist.

## Claims

1. Conductor path structure having a damping device for a component, in particular for an electronic or electromechanical component, in particular a micromechanical component, which has a first base body (10') made of a carrier material (11') comprising a connection area (2) for receiving the oscillation- and/or vibration-damped component (B), the connection area (2) being arranged separated from the area of the base body surrounding it by a free space (7) and being arranged oscillation- and/or vibration damped and coacting with an intrinsic damping device (20) of the conductor path structure (1), wherein the conductor path structure (1) comprises a second base body (10) arranged at a distance under the first base body (10'), wherein above the second base body (10) of the conductor path structure (1) at least one layer (21) made of a damping material, in particular made of a damping adhesive, is provided, so that the intrinsic damping device (20) formed by said at least one layer (21) is arranged between the connection area (2) of the first base body (10'), the free space (7), the area (6) of the first base body (10') surrounding the connection area (2) and the area of the second base body (10) arranged below the connection area (2).

2. Conductor path structure having a damping device for a component, in particular for an electronic or electromechanical component, in particular a micromechanical component, which has a first base body (10') made of a carrier material (11') comprising a connection area (2) for receiving the oscillation- and/or vibration-damped component (B), the connection area (2) being arranged separated from the area of the base body surrounding it by a free space (7) and being arranged oscillation- and/or vibration damped and coacting with an intrinsic damping device (20) of the conductor path structure (1), wherein under the first base body (10') at least one layer (21) made of a damping material, in particular made of a damping adhesive, is arranged, wherein the layer (21) arranged under the first base body (10') is applied on it at a large area, so that the intrinsic damping device (20) formed by said at least one layer (21) is provided under the connection area (2) of the first base body (10') and the area of the first base body (10') surrounding it and under the free space (7).

3. Conductor path structure having a damping device for a component, in particular an electronic or electromechanical component, in particular a micromechanical component, which has a first base body (10') made of a carrier material (11') comprising a connection area (2) for receiving the oscillation- and/or vibration-damped component (B), the connection area (2) being separated from the area of the base body (10') surrounding it by a free space (7) and being arranged oscillation- and/or vibration-damped and coacting with an intrinsic damping device (20) of the conductor path structure (1), wherein the conductor path structure (1) comprises a second base body (10) arranged at a distance under the first base body (10'), and wherein at least one base body (10; 10') of the conductor path structure (1) comprises at least one recess (12), in which a pad (21') made of damping material is provided.

4. Conductor path structure having a damping device for a component, in particular an electronic or electromechanical component, in particular a micromechanical component, which has a first base body (10') made of a carrier material (11') comprising a connection area (2) for receiving the oscillation- and/or vibration-damped component (B), the connection area (2) being separated from the area of the base body (10') surrounding it by a recess (12') and being arranged oscillation- and/or vibration-damped and coacting with an intrinsic damping device (20) of the conductor path structure (1), wherein the conductor path structure (1) comprises a second base body (10) arranged at a distance under the first base body (10'), and wherein at least one base body (10; 10') of the conductor path structure (1) comprises at least one further recess (12), and wherein, for forming an intrinsic damping device (20), in the recesses (12; 12') as well as between the first base body (10') and the second base body (10) a layer (21) made of damping material, in particular a damping adhesive, is provided.

5. Conductor path structure according to one of the previous claims, **characterized in that** below the upper base body (10') at least one further layer (22) of the intrinsic damping device (20) is provided, which is made of a damping material, in particular a damping adhesive.

6. Conductor path structure according to claim 1, **characterized in that**, for forming the intrinsic damping device (20), the at least one layer (21; 22) made of a damping material is applied onto an upper side of the second base body (10) and/or a bottom side of the first base body (10').

7. Conductor path structure according to one of the previous claims, **characterized in that** the conductor paths (4; 4a, 4b) are arranged onto or in the damping layer (21; 22) of the intrinsic damping device (20).

8. Conductor path structure according to claim 3, **characterized in that** the lower base body (10) and the upper base body (10') of the conductor path structure (1) each comprise at least one recess (12; 12'), in each of them a pad (21') made of a damping material is inserted.

9. Conductor path structure according to one of the previous claims, **characterized in that** at least one layer (31) made of a rigid adhesive is provided on at least one base body (10; 10').

10. Conductor path structure according to one of the previous claims, **characterized in that** the conductor path structure (1) is made by a lamination technique.

## Revendications

1. Structure de pistes conductrices avec un dispositif d'amortissement pour un composant, en particulier pour un composant électronique ou électromécanique, en particulier micro-électronique, qui présente un premier corps de base (10') en un matériau support (11') avec une zone de raccord (2) pour la réception du composant avec amortissement des oscillations et/ou vibrations (B), dans laquelle la zone de raccord (2) est disposée, découplée en oscillations et/ou vibrations, séparée de la zone l'entourant du premier corps de base (10') par un espace libre (7) et coopère avec un dispositif d'amortissement intrinsèque (20) de la structure de pistes conductrices (1), dans laquelle la structure de pistes conductrices (1) présente un deuxième corps de base (10) disposé à distance sous le premier corps de base (10'), dans laquelle au moins une couche (21) en un matériau amortissant, en particulier en un adhésif amortissant, est disposée au-dessus du deuxième corps de base (10) de la structure de pistes conductrices (1), de sorte que le dispositif d'amortissement intrinsèque (20) réalisé par ladite au moins une couche (21) soit disposé entre la zone de raccord (2) du premier corps de base (10'), l'espace libre (7), la zone (6) entourant la zone de raccord (2) du premier corps de base (10') et la zone située sous la zone de raccord (2) du deuxième corps de base (10).

2. Structure de pistes conductrices avec un dispositif d'amortissement pour un composant, en particulier pour un composant électronique ou électromécanique, en particulier micro-électronique, qui présente un premier corps de base (10') en un matériau support (11') avec une zone de raccord (2) pour la réception du composant avec amortissement des oscillations et/ou vibrations (B), dans laquelle la zone de raccord (2) est disposée, découplée en oscillations et/ou vibrations, séparée de la zone l'entourant du premier corps de base (10') par un espace libre (7) et coopère avec un dispositif d'amortissement intrinsèque (20) de la structure de pistes conductrices (1), dans laquelle au moins une couche (21) en un matériau amortissant, en particulier en un adhésif amortissant, est disposée sous le premier corps de base (10'), dans laquelle l'au moins une couche (21) disposée sous le premier corps de base (10') est appliquée sur une grande surface sur celui-ci de sorte que le dispositif d'amortissement intrinsèque (20) réalisé par ladite au moins une couche (21) soit disposé sous la zone de raccord (2) du premier corps de base (10') et la zone entourant cette zone de raccord (2) du premier corps de base (10') et sous l'espace libre (7).

3. Structure de pistes conductrices avec un dispositif d'amortissement pour un composant, en particulier pour un composant électronique ou électromécanique, en particulier micro-électronique, qui présente un premier corps de base (10') en un matériau support avec une zone de raccord (2) pour la réception d'un composant avec amortissement des oscillations et/ou vibrations (B), dans laquelle la zone de raccord (2) est disposée, découplée en oscillations et/ou vibrations, séparée de la zone l'entourant du premier corps de base (10') par un espace libre (7) et coopère avec un dispositif d'amortissement intrinsèque (20) de la structure de pistes conductrices (1), dans laquelle la structure de pistes conductrices (1) présente un deuxième corps de base (10) disposé à distance sous le premier corps de base (10'), et dans laquelle au moins un corps de base (10 ; 10') de la structure de pistes conductrices (1) possède au moins un évidement (12), dans lequel un rembourrage (21') en matériau amortissant est inséré.

4. Structure de pistes conductrices avec un dispositif d'amortissement pour un composant, en particulier pour un composant électronique ou électromécanique, en particulier micro-électronique, qui présente un premier corps de base (10') en un matériau support avec une zone de raccord (2) pour la réception d'un composant avec amortissement des oscillations et/ou vibrations (B), dans laquelle la zone de raccord (2) est disposée, découplée en oscillations et/ou vibrations, séparée de la zone l'entourant du premier corps de base (10') par un évidement (12) et coopère avec un dispositif d'amortissement intrinsèque (20) de la structure de pistes conductrices (1), dans laquelle la structure de pistes conductrices (1) présente un deuxième corps de base (10) disposé à distance sous le premier corps de base (10'), et dans laquelle le deuxième corps de base (10) de la structure de pistes conductrices (1) possède au moins un autre évidement (12), dans laquelle une couche (21) en un matériau amortissant, en particulier en un adhésif amortissant, est introduite pour la formation d'un dispositif d'amortissement intrinsèque (20) dans les évidements (12, 12') ainsi qu'entre le premier corps de base (10') et le deuxième corps de base (10).

5. Structure de pistes conductrices selon l'une quelconque des revendications précédentes, **caractérisée** en ce une autre couche (22) du dispositif d'amortissement intrinsèque (20), qui est réalisée en un matériau amortissant, en particulier en un adhésif amortissant, est disposée sous le corps de base supérieur (10').

6. Structure de pistes conductrices selon la revendication 1, **caractérisée en ce que** l'au moins une couche (21 ; 22) en matériau amortissant est appliquée pour la formation du dispositif d'amortissement intrinsèque (20) sur un côté supérieur du deuxième corps de base (10) et/ou un côté inférieur du premier corps de base (10 ; 10').

7. Structure de pistes conductrices selon l'une quelconque des revendications précédentes, **caractérisée en ce que** des pistes conductrices (4 ; 4a, 4b) sont disposées sur ou dans la couche amortissante (21 ; 22) du dispositif d'amortissement intrinsèque (20).

8. Structure de pistes conductrices selon la revendication 3, **caractérisée en ce que** le corps de base inférieur (10) et le corps de base supérieur (10') de la structure de pistes conductrices (1) possèdent respectivement au moins un évidement (12 ; 12'), dans lequel respectivement un rembourrage (21') en matériau amortissant est inséré,

9. Structure de pistes conductrices selon l'une quelconque des revendications précédentes, **caractérisée en ce qu'**au moins une couche (31) en un adhésif rigide est disposée au niveau d'au moins un corps de base (10 ; 10'),

10. Structure de pistes conductrices selon l'une quelconque des revendications précédentes, **caractérisée en ce que** la structure de pistes conductrices (1) est fabriquée par une technique de laminage.
